(19) Europäisches Patentamt / European Patent Office / Office européen des brevets

(11) **EP 3 992 598 A1**

(12) **EUROPEAN PATENT APPLICATION**
published in accordance with Art. 153(4) EPC

(43) Date of publication:
**04.05.2022 Bulletin 2022/18**

(21) Application number: **20828002.4**

(22) Date of filing: **19.06.2020**

(51) International Patent Classification (IPC):
$G01L\ 1/16$ (2006.01)      $G01L\ 23/10$ (2006.01)
$H01L\ 41/053$ (2006.01)      $H01L\ 41/113$ (2006.01)
$H01L\ 41/187$ (2006.01)      $H01L\ 41/22$ (2013.01)
$H01L\ 41/338$ (2013.01)

(52) Cooperative Patent Classification (CPC):
**G01L 1/16; G01L 23/10; H01L 41/053;
H01L 41/113; H01L 41/187; H01L 41/22;
H01L 41/338**

(86) International application number:
**PCT/JP2020/024226**

(87) International publication number:
**WO 2020/262256 (30.12.2020 Gazette 2020/53)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.06.2019 JP 2019121445**

(71) Applicants:
• **Tokyo Institute of Technology**
  **Tokyo 152-8550 (JP)**
• **KOIKE CO., LTD.**
  **Showa-cho**
  **Nakakoma-gun**
  **Yamanashi 409-3861 (JP)**

(72) Inventors:
• **TAKEDA, Hiroaki**
  **Tokyo 152-8550 (JP)**
• **TSURUMI, Takaaki**
  **Tokyo 152-8550 (JP)**
• **KUSAKABE, Hiraku**
  **Tokyo 152-8550 (JP)**
• **USUI, Haruki**
  **Tokyo 152-8550 (JP)**

(74) Representative: **EIP**
**Fairfax House**
**15 Fulwood Place**
**London WC1V 6HU (GB)**

(54) **PIEZOELECTRIC MATERIAL, PIEZOELECTRIC MEMBER, PIEZOELECTRIC ELEMENT, AND PRESSURE SENSOR**

(57)      Provided are a piezoelectric material, a piezoelectric member, a piezoelectric element and a pressure sensor that can be used in high-temperature environments. The piezoelectric material is composed of Sr-substituted akermanite represented by $Ca_{(2-x)}Sr_xMgSi_2O_7$ $(0.1 \le x \le 0.6)$.

*Figure 1*

**EP 3 992 598 A1**

## Description

### Technical Field

The present invention relates to a piezoelectric material, a piezoelectric member, a piezoelectric element and a pressure sensor.

### Background Art

Sensors or actuators in which a piezoelectric element is used are being used for various applications. In addition, piezoelectric materials, which can be used even in high-temperature environments of several hundred degrees Celsius or higher, are being expected to be applied to, for example, combustion pressure sensors in engines, ultrasonic sensors that constantly monitor high-temperature plants in thermal power stations, and the like.

Preferable characteristics required for piezoelectric materials usable in high-temperature environments are (1) a high phase transition temperature, (2) high electric resistivity even at high temperatures, (3) high temperature stability elicited by piezoelectric characteristics, (4) small pyroelectric characteristics and (5) a high compressive strength, but no materials satisfying these five requirements have been thus far discovered.

Citation List

Patent Document

Patent Document 1: Japanese Patent No. 5966683
Patent Document 2: Patent Publication JP-A-2017-183550

### Summary

Technical Problem

As a piezoelectric body of a melilite-type crystal, gehlenite ($Ca_2Al_2SiO_7$) has been proposed (refer to Patent Document 1). This crystal satisfies requirements of high-temperature resistance, pyroelectric inactivity and high insulating properties, which are required for combustion pressure sensor materials, but has a problem with the compressive strength, i.e., the compressive strength is low in a cutting orientation satisfying the piezoelectric constant $d_{14}$ of 7.0 pC/N and the piezoelectric constant $d_{36}$ is as low as 1.0 pC/N in a cutting orientation exhibiting a high compressive strength. In addition, as another piezoelectric body of a melilite-type crystal, akermanite ($Ca_2MgSi_2O_7$) has also been proposed (refer to Patent Document 2), but akermanite has a problem with phase transition that occurs at near 80°C.

An aspect of the present invention is to provide a piezoelectric material, a piezoelectric member, a piezoelectric element and a pressure sensor that can be used in high-temperature environments.

Solution to Problem

In order to improve the compressive strength, which is a problem of gehlenite ($Ca_2Al_2SiO_7$), the present inventors paid attention to akermanite ($Ca_2MgSi_2O_7$), which belongs to the same melilite-type crystal family ($A_2BT_2O_7$) as gehlenite, and found a novel piezoelectric single crystal that has overcome the problem of akermanite (phase transition at near 80°C).

A piezoelectric material according to the present invention is a piezoelectric material composed of Sr-substituted akermanite represented by $Ca_{(2-x)}Sr_xMgSi_2O_7$ ($0.1 \leq x \leq 0.6$). According to the above-described configuration, it is possible to prevent the phase transition of akermanite, and the piezoelectric material satisfies the above-described five requirements.

A piezoelectric member according to the present invention is a piezoelectric member containing, as a main component, the above-described piezoelectric material.

According to the above-described configuration, the piezoelectric member contains, as a main component, the above-described piezoelectric material and is thus dominated by the piezoelectric characteristics of the piezoelectric material. Therefore, this piezoelectric member becomes excellent in terms of temperature stability from room temperature through high-temperature environments.

The piezoelectric member may contain a material other than the above-described piezoelectric material as an accessory component and may contain an impurity that is inevitably contained during production.

The piezoelectric member is preferably cut in an orientation of (ZXt) θ (30° ≤ θ ≤ 60°) when two a axes of a unit lattice of the tetragonal crystal of the Sr-substituted akermanite are X axis and Y axis and c axis is Z axis. According to the above-described configuration, the piezoelectric member is capable of using a high piezoelectric effect.

A piezoelectric element according to the present invention has the above-described piezoelectric member and at least a pair of electrodes provided on surfaces that are orthogonal to a stress application surface of the piezoelectric member and face each other. According to the above-described configuration, the piezoelectric element is capable of efficiently detecting charges generated due to a transverse piezoelectric effect.

A pressure sensor according to the present invention has a diaphragm and the above-described piezoelectric element. According to the above-described configuration, the pressure sensor detects charges that are generated in the piezoelectric member due to stress that arises from pressure that is applied through the diaphragm and is transmitted to the stress application surface of the piezoelectric member and thereby measures the pressure.

Advantageous Effects of Invention

According to the piezoelectric material of the present invention, it is possible to provide a material that satisfies the five requirements of (1) a high phase transition temperature, (2) high electric resistivity even at high temperatures, (3) high temperature stability of piezoelectric characteristics, (4) small pyroelectric characteristics and (5) a high compressive strength. This makes it possible for a piezoelectric member, a piezoelectric element and a pressure sensor in which this piezoelectric material is used to be used even in high-temperature environments.

**Brief Description of Drawings**

Fig. 1 is a schematic view showing the configuration of a piezoelectric element according to the present embodiment.

Fig. 2 is a view for describing a cutting orientation of a piezoelectric member that is used in the piezoelectric element according to the present embodiment.

Fig. 3 is a flowchart showing the flow of a method for producing the piezoelectric element according to the present embodiment.

Fig. 4 is a schematic view showing the configuration of a crystal growth device of a piezoelectric material that is used in the piezoelectric element according to the present embodiment.

Fig. 5 is a schematic view showing the configuration of a pressure sensor according to the present embodiment, (a) of Fig. 5 is a vertical cross-sectional view, (b) of Fig. 5 is a transverse cross-sectional view in a direction of a line B-B in (a) of Fig. 5, and (c) of Fig. 5 is a transverse cross-sectional view in a direction of a line C-C in (a) of Fig. 5.

Fig. 6 is a view showing DSC measurement results of samples with individual formulations.

Fig. 7 is an external view of a $Ca_{(2-x)}Sr_xMgSi_2O_7$ (x = 0.10) crystal.

Fig. 8 is an external view of a $Ca_{(2-x)}Sr_xMgSi_2O_7$ (x = 0.30) crystal.

Fig. 9 is a view showing c-axis Laue spots of $Ca_{(2-x)}Sr_xMgSi_2O_7$ (x = 0.10).

Fig. 10 is a view showing a-axis Laue spots of $Ca_{(2-x)}Sr_xMgSi_2O_7$ (x = 0.30).

Fig. 11 is a view showing the temperature dependencies of piezoelectric constants measured from samples of piezoelectric elements of the present examples.

Fig. 12 is a view showing the temperature dependencies of piezoelectric constants measured from samples of piezoelectric elements of the present examples and comparative examples.

Fig. 13 is a graph showing the temperature dependencies of electric resistivity measured from the samples of the piezoelectric elements of the present examples and the comparative examples.

Fig. 14 is a view showing a Weibull plot of the compressive break strength test results of the samples of the piezoelectric elements of the present examples.

**Description of Embodiments**

Hereinafter, embodiments of the present invention will be described with appropriate reference to figures.

[Piezoelectric material]

A piezoelectric material according to the present embodiment is a piezoelectric material represented by $Ca_{(2-x)}Sr_xMgSi_2O_7$ ($0.1 \leq x \leq 0.6$). That is, the piezoelectric material according to the present embodiment is composed of Sr-substituted akermanite obtained by substituting some of Ca atoms in akermanite ($Ca_2MgSi_2O_7$) with Sr atoms.

Akermanite ($Ca_2MgSi_2O_7$) has a high piezoelectric constant of $d_{36} = 4.3$, but phase transition occurs in akermanite at near 80°C due to the formation of an incommensurate structure. The piezoelectric constant does not disappear even in high-temperature phases, but the piezoelectric constant significantly changes at near this phase transition temperature, which creates a problem with use in sensor application. The present inventors substituted Ca atoms in A sites with Sr atoms to lower the phase transition temperature and suppress the occurrence of phase transition in the vicinity of the operating temperature region, thereby finding a material for combustion pressure sensors that satisfies the above-described five requirements (1) to (5).

Specifically, the piezoelectric material according to the present embodiment exhibits the following effects.

1. Approximately the same piezoelectric constant as quartz is exhibited.

2. Phase transition and pyroelectricity are not shown.

3. The compressive strength is as high as approximately 1 GPa.

4. The change in the piezoelectric constant over temperature is as small as that of langatate.

5. A crystal can be grown by the Czochralski method.

6. Rare elements (lanthanoids and transition elements) are not used.

As described above, the piezoelectric material according to the present embodiment has a high piezoelectric constant, undergoes no phase transition even at high temperatures, does not change significantly in the piezoelectric constant (piezoelectric characteristics) and is stable. That is, the use of the piezoelectric material according to the present embodiment makes it possible to provide piezoelectric elements that can be used even in high-temperature environments.

[Configuration of piezoelectric element]

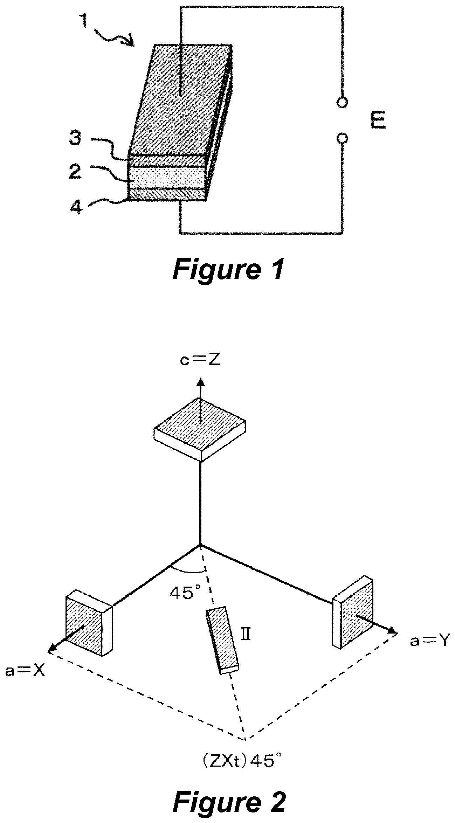

Next, the configuration of a piezoelectric element according to a first embodiment of the present invention will be described with reference to Fig. 1 and Fig. 2. A piezoelectric element 1 according to the first embodiment shown in Fig. 1 is made up of a piezoelectric member 2 and electrodes 3 and 4.

The piezoelectric element 1 has a pair of the electrode 3 and the electrode 4 provided on two surfaces, which face each other, of the rectangular piezoelectric member 2 excised (cut out) in a predetermined crystal orientation. In addition, when the piezoelectric member 2 deforms due to application of stress, charges are generated on the surfaces of the piezoelectric member 2 in proportion to the stress, that is, in proportion to the amount of deformation, due to the piezoelectric effect (piezo effect). In addition, a voltage E is generated between the electrode 3 and the electrode 4 due to these charges. In addition, when the voltage E is applied between the electrode 3 and the electrode 4, the piezoelectric member 2 deforms in proportion to the applied voltage due to the converse piezoelectric effect (converse piezo effect).

The use of the piezoelectric effect makes it possible to apply the piezoelectric element 1 to a variety of sensors such as pressure sensors or ultrasonic sensors. In addition, the use of the converse piezoelectric effect also makes it possible to apply the piezoelectric element 1 to oscillators, actuators, or the like.

In addition, in the case of being used as a sensor, the piezoelectric element 1 detects charges generated on the surfaces of the piezoelectric member 2 through the electrode 3 and the electrode 4. Here, "detecting charges" means that a physical amount attributed to charges generated by the application of stress to the piezoelectric member 2 is detected (measured). For example, "detecting charges" means that the electric quantity of the generated charges is detected (measured) or a voltage generated between the electrode 3 and the electrode 4 is detected (measured) based on the generated charges.

In addition, in the case of using the piezoelectric material according to the present embodiment as the piezoelectric member 2, the piezoelectric element 1 in which the transverse piezoelectric effect (d31 mode) is used is configured. The transverse piezoelectric effect refers to a piezoelectric effect with which a direction in which stress is applied and the polarization direction of charges that are generated by the application of the stress become orthogonal to each other. In the present embodiment, an end surface of the rectangular piezoelectric member 2 in the longitudinal direction (the front surface or the rear surface in Fig. 1) is a stress application surface. Therefore, charges are generated in a polarized manner on the surfaces of the piezoelectric member 2 in a direction that is orthogonal to the normal line to the stress application surface, which is in a stress application direction, (vertical direction in Fig. 1). In addition, the electrodes 3 and 4 are provided on the surfaces on which the charges are generated.

The transverse piezoelectric effect also generates charges in a polarized manner on the surfaces of the piezoelectric member 2 in a different direction that is orthogonal to the stress application direction (horizontal direction in Fig. 1). Therefore, a pair of facing electrodes may be provided on side surfaces (the right and left side surfaces in Fig. 1) of the piezoelectric member 2 in place of or in addition to the electrodes 3 and 4 provided on the upper and lower surfaces.

(Piezoelectric member)

The piezoelectric member 2 is a rectangular (plate-shaped) crystal piece cut in a predetermined crystal orientation from a crystal bulk body of the piezoelectric material according to the present embodiment. Specifically, the piezoelectric member 2 is a member cut in an orientation of (ZXt) $\theta$ ($30° \leq \theta \leq 60°$) when the two a axes of the unit lattice of the tetragonal crystal of Sr-substituted akermanite are regarded as the X axis and the Y axis and the c axis is regarded as the Z axis.

Fig. 2 is an example of a tetragonal crystal having piezoelectricity and cleavability and shows the piezoelectric member 2 made into a substantially rectangular shape by cutting the tetragonal crystal having piezoelectricity and cleavability in an orientation of (ZXt) 45°.

The two a axes of the unit lattice of the tetragonal crystal are regarded as the X axis and the Y axis and the c axis is regarded as the Z axis. At this time, cutting the crystal in an orientation of (ZXt) $\theta$ at an angle $\theta$ means that the crystal is cut out on a surface for which the Z axis is a normal line (Z surface), a surface for which an axis obtained by rotating the X axis around the Z axis by $\theta$ (Xz axis) is a normal line (Xz surface) and a surface for which an axis obtained by rotating the Y axis around the Z axis by $\theta$ (Yz axis) is a normal line (Yz surface). The piezoelectric member 2 shown in Fig. 2 is cut in an orientation for which $\theta$ is set to 45°, that is, an orientation of (ZXt) 45°.

Usually, in a piezoelectric member formed by cutting a tetragonal crystal having piezoelectricity and cleavability in an orientation of (ZXt) $\theta$, when stress is applied to the Xz surface (a surface for which an axis obtained by rotating the X axis around the Z axis by 45° is a normal line), charges are generated on the Z surface (the surface for which the Z axis is a normal line) in a quantity in proportion to the magnitude of the stress. At this time, charges that are generated on the Z surface due to the stress applied to the Xz surface are proportional to the piezoelectric constant d36 and {sin (2$\theta$)}12. Therefore, in the piezoelectric member 2, $\theta$, which is the rotation angle, is set to 45° in order to maximize the quantity of charges generated. However, $\theta$ is not limited to 45°, and, even at rotation angles of 30° to 60°, the charges that are generated on the Z surface due to the stress applied to the Xz surface are capable of securing 85% or more of the charge quantity compared with a case where $\theta$ is set to 45°. Therefore, among piezoelectric members obtained by cutting a tetragonal crystal having piezoelectricity and cleavability in an orientation of (ZXt) $\theta$, piezoelectric members for which $\theta$ is set in a range of 30° to 60° can be preferably used as a piezoelectric element for pressure sensors. The piezoelectric constant d36 is an intrinsic value of the tetragonal crystal that is used for the piezoelectric member 2.

In a tetragonal crystal having cleavability, an arbitrary surface parallel to a surface for which the Z axis (c axis) of the unit lattice of the tetragonal crystal is a normal line serves as a cleavage surface. Therefore, in the piezoelectric member 2, an arbitrary cross section parallel to a surface for which the Z axis is a normal line serves as a cleavage surface.

As described above, when stress is applied in a direction of the stress application axis, the transverse piezoelectric effect also generates polarized charges on the Yz surface (the surface for which the axis obtained by rotating the Y axis around the Z axis by 45° is a normal line), which is in a different direction that is orthogonal to the stress application axis. Therefore, a piezoelectric element can also be configured by providing electrodes on surfaces for which this axis is a normal line.

In addition, a crystal piece cut out by cutting in a different crystal orientation may also be used as the piezoelectric member 2. In addition, the shape of the piezoelectric member 2 is not limited to the rectangular shape and may have any of a variety of shapes such as a disc shape and a rod shape depending on application.

(Electrodes)

The electrodes 3 and 4 are provided on the charge generation surfaces of the rectangular piezoelectric member 2, respectively. Preferably, the electrodes 3 and 4 are provided on the two Z surfaces, which are the charge generation surfaces of the piezoelectric member 2, respectively. As the electrodes 3 and 4, it is possible to use a metallic material having a higher melting point than high-temperature environments in which the piezoelectric element 1 is used. Particularly, examples of a material that can be used even in high-temperature environments of 800°C or higher include Au, platinum (Pd), palladium (Pt) and Ag-Pd alloys. In addition, in a case where the electrodes 3 and 4 are used at a relatively low temperature, a Ag paste can also be used.

The electrodes 3 and 4 can be formed on the front surface and the rear surface of the piezoelectric member 2, respectively, using the above-described material by a method such as a coating method, a deposition method, a plating method or a sputtering method.

[Method for producing piezoelectric element]

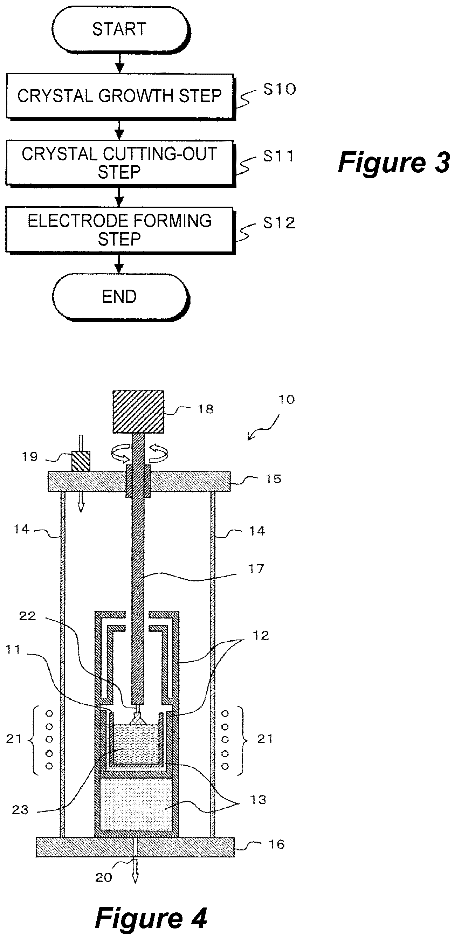

Next, a method for producing the piezoelectric element 1 will be described with reference to Fig. 3 (with appropriate reference to Fig. 1 and Fig. 2).

As shown in Fig. 3, the method for producing the piezoelectric element 1 includes a crystal growth step S10 of producing a crystal bulk body of a piezoelectric material, a crystal cutting-out step S11 of cutting out the piezoelectric member 2 from the crystal bulk body in a predetermined crystal orientation and an electrode forming step S12 of forming the electrodes 3 and 4 on predetermined surfaces that serve as the charge-generation surfaces of the cut-out piezoelectric member 2, which are carried out in this order.

(Crystal growth step)

First, in the crystal growth step S10, a crystal bulk body that is a piezoelectric material is produced. The crystal bulk body can be produced as a rod-shaped single crystal by the Czochralski method. The Czochralski method is used as a method for producing semiconductor materials, and the crystal bulk body that is used in the present invention can also be produced using the same crystal growth device.

Here, an example of the crystal growth device by the Czochralski method will be described with reference to Fig. 4. As shown in Fig. 4, a crystal growth device 10 is configured to include a crucible 11, a crucible 12, alumina bubbles 13, a quartz tube 14, an upper lid 15, a lower lid 16, a crystal pull rod 17, a load cell 18, a gas introducing portion 19, an exhaust port 20 and a heating portion 21.

The crucible 11 is a container into which a raw material is injected and which stores melt 23 of the raw material that has been heated and melted with the heating portion 21. As the crucible 11, for example, a container made from iridium (Ir, melting point of approximately 2460°C), which is a metal having a high melting point, is used.

The crucible 12 is configured to surround the crucible 11 and a crystal pull region and partially forms a double structure such that a favorable heat-retaining property can be obtained. In the present embodiment, as the crucible 12, a zirconia ($ZrO_2$) crucible is used.

In addition, the alumina bubbles 13 are loaded into a gap between the crucible 11 and the crucible 12.

The alumina bubbles 13 are hollow spherical alumina ($Al_2O_3$) particles. When the alumina bubbles 13 are loaded into the gap between the crucible 11 and the crucible 12, deformation of the Ir crucible 11 is prevented, and the temperature-retaining property near the crucible 11 can be enhanced.

The quartz tube 14 is a container for holding a reaction atmosphere by covering the outsides of the crucibles 11 and 12, which are reaction portions, and blocking external air. The upper and lower portions of the quartz tube 14 are sealed with the upper lid 15 and the lower lid 16.

The upper lid 15 and the lower lid 16 are provided at the upper end and the lower end of the quartz tube 14, respectively, and are intended to hold the reaction atmosphere together with the quartz tube 14.

The upper lid 15 has a bearing that holds the crystal pull rod 17 in the center so as to be capable of rotating around the central axis of the crystal pull rod 17 and capable of moving in the axial direction. In addition, the gas introducing portion 19 for controlling the reaction atmosphere is provided in a part of the upper lid 15 and configured so as to supply argon (Ar) gas, nitrogen gas or the like.

In addition, the exhaust port 20 is provided in the lower lid 16.

The crystal pull rod 17 is intended to grip a seed crystal 22 at the front end (the lower end in the figure) and to pull a crystal from the melt 23 of the raw material that is held in the crucible 11. The crystal pull rod 17 is gripped by the load cell 18 in the upper portion and configured so as to be capable of rotating around the central axis and moving in the vertical direction by driving means such as a motor, which is not shown.

The load cell 18 is a load meter that grips the upper portion of the crystal pull rod 17 and measures the weights of the crystal pull rod 17 and a crystal that grows at the lower end of the crystal pull rod 17. The load cell 18 controls the crystal growth device 10 so as to stop crystal growth when the weight of the grown crystal reaches a predetermined weight.

The gas introducing portion 19 is provided in the upper lid 15 and is gas introduction control means such as a valve for introducing gas for controlling the reaction atmosphere into the inside of the quartz tube 14.

As the gas that is introduced as the reaction atmosphere, inactive or poorly active Ar gas or nitrogen gas can be used. In addition, a small amount of oxygen gas may be mixed with the above-described gas and introduced into the inside of the quartz tube 14 in order to suppress generation of an oxygen defect in a crystal to be produced.

In addition, the exhaust port 20, which serves as an exit for the flow of the gas that is introduced from the gas introducing portion 19, is provided in the lower lid 16.

The heating portion 21 is heating means for melting the raw material that has been injected into the crucible 11. In the present embodiment, a radiofrequency (RF) coil is provided as the heating portion 21 so as to surround the outside of a region in the quartz tube 14 in which the crucible 11 is disposed. When electric power is supplied to the RF coil, a magnetic field is generated in the RF coil, this magnetic field generates an induced current in the crucible 11, which is metal, and the crucible 11 is heated to a high temperature. Therefore, the raw material that is held in the crucible 11 is melted.

The heating portion 21 is not limited to means for radiofrequency induction heating, and different heating means such as a heater may also be used.

The seed crystal 22 serves as a nucleus for crystal growth at the time of pulling a crystal from the melt 23. The seed crystal 22 is preferably a single crystal of a crystal to be grown, but a polycrystal having the same formulation as the crystal to be grown can also be used. In addition, a platinum (Pt) rod, an Ir rod or the like can also be used.

The seed crystal 22 may have a prism shape, but the shape is not limited thereto. The size of the seed crystal 22 can be appropriately determined depending on the size of the crucible 11 that holds the melt 23 or the size of the crystal to be grown. For example, in a case where the crucible 11 has a cylindrical shape with a size of 50 mm in inner diameter and 50 mm in height, the cross section of the seed crystal 22 may have a prism shape that is 3 mm x 3 mm to 5 mm x 5 mm and 20 to 50 mm in length.

Next, the crystal growth step S10 of producing a crystal bulk body of a piezoelectric material will be described. The crystal growth step S10 can be carried out using the crystal growth device 10 shown in Fig. 4.

First, as raw materials, a compound containing Ca such as powder-form calcium carbonate ($CaCO_3$), a compound containing Sr such as strontium carbonate ($SrCO_3$), a compound containing Mg such as magnesium oxide (MgO) and a compound containing Si such as silicon oxide ($SiO_2$) are weighed and mixed such that a formulation of $Ca_{(2-x)}Sr_xMgSi_2O_7$ ($0.1 \leq x \leq 0.6$) is formed, that is, the mole ratio becomes 2-x:x:1:2.

Next, the powder mixture of the above-described raw materials is put into the crucible 11 and installed in the crystal growth device 10. In addition, Ar gas or nitrogen gas is introduced from the gas introducing portion 19 to adjust the reaction atmosphere. At this time, a small amount of oxygen gas may be mixed and introduced from the gas introducing portion 19.

In addition, the seed crystal 22 is mounted in the front end of the crystal pull rod 17.

The seed crystal 22 is preferably a single crystal of the piezoelectric material according to the present embodiment as described above, but may be a polycrystal with the same formulation, or a Pt rod, an Ir rod or the like may be used.

Next, electric power is supplied to the RF coil as the heating portion 21 from a power supply, which is not shown, and the raw materials in the crucible 11 are melted by the radiofrequency induction heating of the crucible 11.

Next, the crystal pull rod 17 is lowered to immerse the seed crystal 22 into the melt 23 of the raw materials. In addition, the crystal pull rod 17 is slowly pulled upward at a predetermined rate while being slowly rotated in a predetermined direction at a predetermined rotation rate. The rotation rate and pulling rate of the crystal pull rod 17 are appropriately set depending on the size of the crystal to be grown.

A rod-shaped single crystal bulk body of the piezoelectric material according to the present embodiment is produced with the above-described operations.

(Crystal cutting-out step)

Next, in the crystal cutting-out step S11, a crystal piece is cut out as the piezoelectric member 2 from the crystal bulk body produced in the crystal growth step S10 by cutting in a predetermined crystal orientation, for example, cutting in (ZXt) 45° indicated by II in Fig. 2. The crystal piece can be cut out from the piezoelectric material using a wire saw, a blade saw or the like that is used to cut out semiconductor wafers.

In addition, the surface of the cut-out piezoelectric member 2 may be mirror-polished as necessary.

(Electrode forming step)

Next, in the electrode forming step S12, the electrode 3 and the electrode 4 are formed on the front surface and rear surface of the piezoelectric member 2 cut out in the crystal cutting-out step S11, respectively.

The electrodes 3 and 4 can be formed on the piezoelectric member 2 by applying a paste of a powder-form metallic material to the surfaces thereof on which the electrodes 3 and 4 are to be formed. A baking treatment may be further carried out after the application. In addition, the electrodes 3 and 4 may be formed by a deposition method, a plating method, a sputtering method or the like depending on the application.

The piezoelectric element 1 is produced by the above-described steps.

[Configuration of pressure sensor]

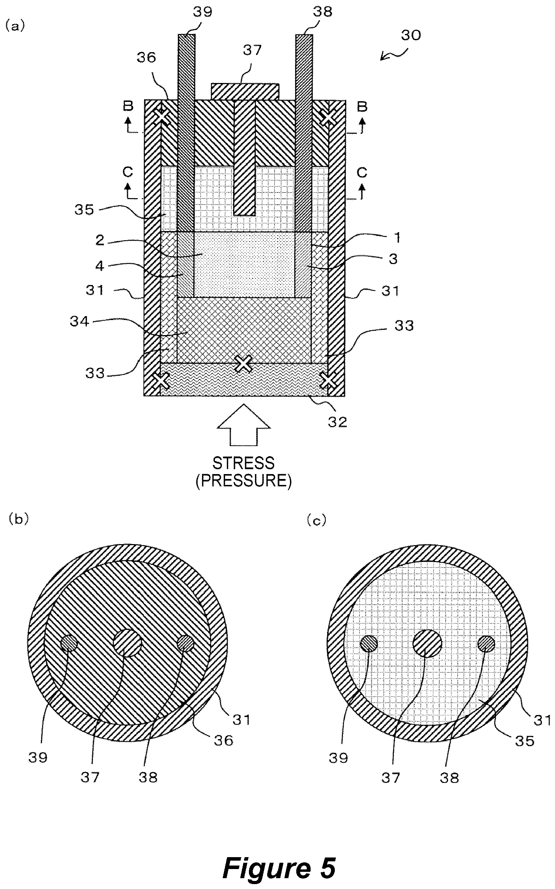

Next, an example of a pressure sensor in which the piezoelectric element according to the present embodiment is used will be described with reference to Fig. 5.

A pressure sensor 30 is made up of a case material 31, a diaphragm 32, an insulating sleeve 33, a base 34, the piezoelectric element 1, an alumina plate 35, a sealing material 36, a fixing screw 37 and electric wires 38 and 39 as shown in Fig. 5(a).

The pressure sensor 30 according to the present embodiment is directly attached to, for example, a combustion chamber in order to measure the combustion chamber pressure of an engine. That is, the pressure sensor 30 is a sensor that can be used in high-temperature environments. Therefore, each member that configures the pressure sensor 30 is formed using a heat-resistant material capable of withstanding several hundred degrees Celsius or higher.

The pressure sensor 30 transmits stress generated due to pressure applied to the diaphragm 32 to the piezoelectric member 2 in the piezoelectric element 1 through the base 34 and detects charges that are generated in proportion to the magnitude of the stress transmitted to the piezoelectric member 2 on the charge generation surfaces provided with the electrodes 3 and 4 of the piezoelectric element 1 with charge detection means (not shown) such as an electric quantity measuring instrument or a voltage measuring instrument that is connected to the electric wires 38 and 39, thereby measuring the pressure.

In the present embodiment, the piezoelectric element 1 converts stress (pressure) applied to the piezoelectric member 7 to a charge quantity using the transverse piezoelectric effect. The pressure sensor 30 according to the present embodiment measures pressure applied to the diaphragm 32 based on the charge quantity detected through the electrodes 3 and 4 in this piezoelectric element 1.

The case material 31 is a cylindrical stainless steel case. The diaphragm 32 is provided at the lower end of the case material 31. The diaphragm 32 is a disc-shaped stainless steel member, and the lower surface of the diaphragm 32 is a pressure-receiving surface that receives pressure, which is the measurement subject. The piezoelectric element 1 is provided on the upper surface of the diaphragm 32 through the glass base 34.

In addition, the alumina insulating sleeve 33 is provided between the piezoelectric element 1 and the inner circumferential surface of the case material 31 and between the base 34 and the inner circumferential surface of the case material 31.

As the piezoelectric element 1 in the present embodiment, the piezoelectric element 1 according to the first embodiment shown in Fig. 1 is used. In addition, the piezoelectric element 1 is provided on the upper surface of the base 34 and configured to cause stress generated due to pressure received by the diaphragm 32 on the pressure-receiving surface to be transmitted to the stress application surface of the piezoelectric member 2 through the base 34.

In addition, in order to use the transverse piezoelectric effect in the piezoelectric element 1, the electrodes 3 and 4 are provided to face each other in a transverse direction, which is a direction that is orthogonal to a direction in which stress that the piezoelectric member 2 receives is applied, or in the transverse direction and a direction perpendicular to the paper on the side surfaces of the piezoelectric member 2.

The shape of the piezoelectric element 1 may be a prism shape as shown in Fig. 1 or may be a cylindrical shape in accordance with the shape of the case material 31. In addition, a plurality of plate-shaped piezoelectric elements may be used, and the electrodes of the same polarity in the individual piezoelectric elements may be electrically connected to the electric wire 38 or 39 of the corresponding polarity.

In addition, the electrode 3 and the electrode 4 in the piezoelectric element 1 are electrically connected to ends on one side of the electric wire 38 and the electric wire 39, respectively. The electric wires 38 and 39 are preferably electric wires coated with ceramic felt that is heat-resistant enough to be used in high-temperature environments. In addition, as shown in Fig. 5(a), Fig. 5(b) and Fig. 5(c), the electric wires 38 and 39 pass through through-holes provided in the alumina plate 35 and the sealing material 36, and ends on the other side of the electric wires 38 and 39 are exposed from the upper surface of the sealing material 36 and connected to the external charge detection means (not shown).

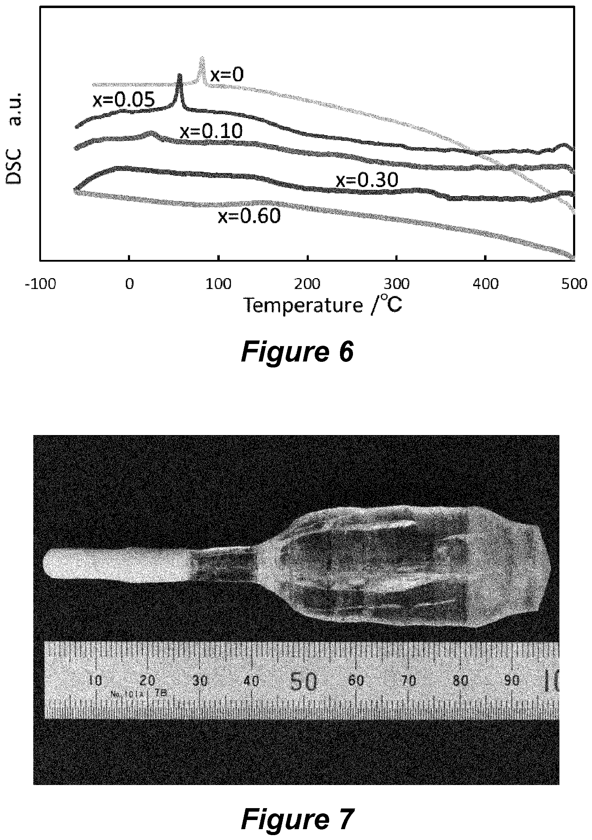

The alumina plate 35, which is an insulating member, is provided on the upper surface side of the piezoelectric element 1, and furthermore, the stainless steel sealing material 36 is provided on the upper portion of the alumina plate 35. In addition, the case material 31 is joined to the diaphragm 32 and the sealing material 36 at places indicated by "white letter X's" in (a) of Fig. 6. In addition, the diaphragm 32 and the base 34 are also joined together in the central portions.

In addition, the fixing screw 37 is provided in the central portion of the sealing material 36 in a plan view and passes through the sealing material 36. The front end of the fixing screw 37 is screwed up to approximately the center of the alumina plate 35 in the thickness direction. The fixing screw 37 fixes the positions of the individual members that are disposed in the case material 31. As the fixing screw 37, for example, a Fe-Ni-based alloy fixing screw can be used.

The shape of the case material 31 is not limited to the cylindrical shape and can also be made into a quadratic prism shape, a polygonal prism shape or the like. In addition, the pressure sensor 30 can also be configured to, for example, be provided with a screw thread on the outer circumference of the front end portion of the case material 31 and be screwed into a predetermined mounting hole that communicates with an engine combustion chamber by the same method as for mounting of spark plugs, thereby being mounted.

[Operation of pressure sensor]

Next, the operation of the pressure sensor 30 will be subsequently described with reference to Fig. 5.

The pressure sensor 30 receives pressure in a combustion chamber or the like in an engine on the pressure-receiving surface, which is the lower surface of the diaphragm 32. Stress generated due to the pressure received by the diaphragm 32 is transmitted to the piezoelectric member 2 in the piezoelectric element 1 through the base 34. The piezoelectric member 2 deforms due to the transmitted stress and generates charges in proportion to the amount of deformation due to the transverse piezoelectric effect. Positive and negative charges generated in the piezoelectric member 2 are measured with the charge detection means (not shown) connected through the electrodes 3 and 4 and the electric wires 38 and 39 as physical amounts such as a voltage or an electric quantity attributed to the generated charges. The pressure received by the diaphragm 32 can be obtained based on the measured voltage, electric quantity or the like.

Examples

Determination of synthesis formulation by DSC

First, for samples of individual formulations, the occurrence of phase transition was inspected by DSC measurement.

For formulations of $Ca_{(2-x)}Sr_xMgSi_2O_7$ (x = 0, 0.05, 0.10, 0.30 and 0.60), powder-form samples were produced. As raw materials, $CaCO_3$, $SrCO_3$, $MgO$ and $SiO_2$, all of which had a purity of 99.99%, were used.

The raw materials were weighed, mixed in a wet manner in an agate mortar and calcined in a platinum crucible at 1250°C under conditions of a temperature rise rate of 15 °C/min and a holding time of four hours. The calcined powders were pulverized in a wet manner in the agate mortar and CIP-molded into a rod shape at 100 MPa. The rods were fired on a platinum plate at 1350°C under conditions of a temperature rise rate of 15 °C/min and a holding time of four hours, and sintered bodies were cut out in a finer rod shape with a low-speed diamond cutter and partially melted and recrystallized by heating by light concentration of a $CO_2$ laser. Recrystallized portions were pulverized in a wet manner in the agate mortar, and crystal phases were confirmed by powder XRD. As a result, intended crystal structures were obtained, and no foreign phases were confirmed. Therefore, it was determined that DSC measurement was to be carried out using these powders.

The individual produced samples of $Ca_{(2-x)}Sr_xMgSi_2O_7$ (x = 0, 0.05, 0.10, 0.30 and 0.60) were pulverized, then, sufficiently dried at 120°C in a drying furnace, and then measured. As the reference sample, $Al_2O_3$ powder was used, and the individual samples were put into alumina containers, respectively, and measured in a sealed state. The measurement was carried out twice. In the first measurement, the individual samples were measured in a range of room temperature to 400°C at a temperature rise rate of 20 °C/min in order to grasp the tendencies of the samples. In the second measurement, samples that had been selected as candidates based on the results of the first measurement were cooled using liquefied nitrogen in a range of 500°C to -60°C at 20 °C/min and measured. DSC curves obtained from the second measurement are shown in Fig. 6.

From these results, it was found that the peaks of phase transition became blunt with x of 0.10 or more and the peaks of phase transition were not shown with x of 0.30 or more. Based on these results, the formulations for which a single crystal was to be grown were determined as x = 0.10 and 0.30.

Single crystal growth by Czochralski (Cz) method

Raw materials were prepared according to formulations of $Ca_{(2-x)}Sr_xMgSi_2O_7$ (x = 0.10, 0.30). As the raw materials, similar to those for the DSC samples, $CaCO_3$, $SrCO_3$, $MgO$ and $SiO_2$, all of which had a purity of 99.99%, were used. The raw materials were weighed and calcined on a platinum plate at 1250°C at a temperature rise rate of 15 °C/min for a holding time of four hours. The calcined powders were pulverized with a ball mill and molded into a pellet shape with $\varphi$44 by uniaxial pressing at 100 MPa. The pellets were fired on the platinum plate at 1350°C at a temperature rise rate of 15 °C/min for a holding time of four hours and loaded into an Ir crucible for single crystal growth.

The raw materials in the Ir crucible were melted in an Ar atmosphere using a heating portion of a single crystal growth device. The raw materials were slowly cooled after being confirmed to be completely melted, and a sintered body was added thereto. These operations were repeated, and melt was prepared as much as approximately 80% of the volume of the Ir crucible.

The produced melts were held for one hour in a completely molten state, the absence of air bubbles on the liquid surface was visually confirmed, and then a seed crystal that had been rotated at 15 rpm was brought into contact with the liquid surface. In the case of the single crystal growth with x = 0.10, it was not possible to prepare a single crystal of Sr-substituted akermanite that was to serve as a seed crystal, and a polycrystal with the same formulation was thus used. In a case where the seed crystal was melted after the contact, the output of a radiofrequency oscillator was lowered, and, conversely, in a case where a large amount of the melt crystallized, the output was raised, thereby confirming an output with which stable growth could be expected. In the initial phase of the growth, the output was adjusted such that the thickness of a crystal to be grown became approximately 5 mm, and the crystal was grown at a pulling rate of 1.5 mm/h for approximately five hours.

Next, the output of the radiofrequency oscillator was adjusted such that the diameter of the single crystal estimated from the value of the load cell with the pulling rate of the axis set to 1 mm/h became thick at 2 mm/h, and, once the diameter reached approximately 20 mm, the single crystal was grown such that the diameter became constant. In the growth of this straight torso portion, the output was adjusted every 30 minutes such that the diameter became constant.

The straight torso portion was continuously grown until the value of the load cell showed an unnatural change. At the time of ending the growth, the pulling rate was changed to 1.5 mm/h, the output was then adjusted such that a change in the diameter of the crystal to be grown reached -3 mm/h, and the crystal was cut away from the melt.

Fig. 7 shows the appearance of the grown crystal of $Ca_{(2-x)}Sr_xMgSi_2O_7$ (x = 0.10).

For $Ca_{(2-x)}Sr_xMgSi_2O_7$ (x = 0.10), it was possible to grow a colorless transparent crystal.

A rod that was long in the a-axis direction was cut out from the single crystal with x = 0.10 and used as a seed crystal for growing a single crystal with x = 0.30. On this formulation as well, single crystal growth was carried out in the same manner.

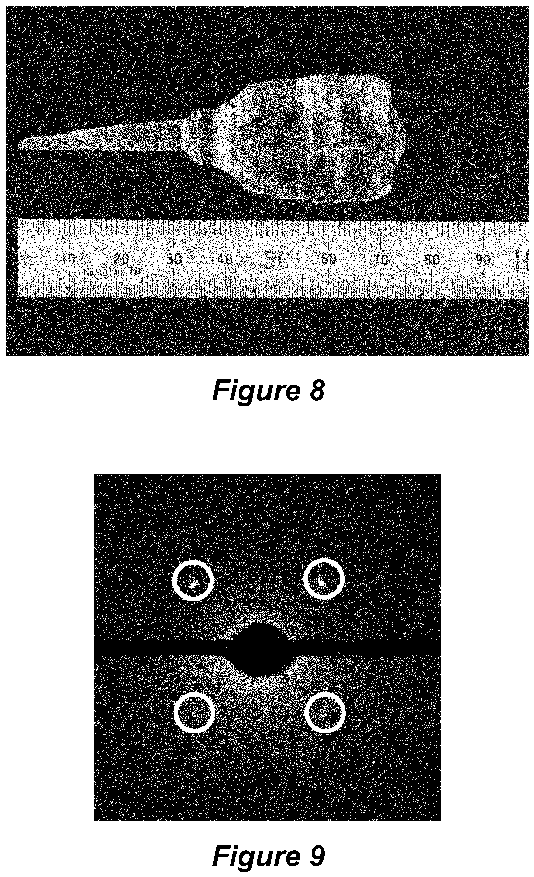

Fig. 8 shows the appearance of the grown crystal of $Ca_{(2-x)}Sr_xMgSi_2O_7$ (x = 0.30). For $Ca_{(2-x)}Sr_xMgSi_2O_7$ (x = 0.30) as well, it was possible to grow a colorless transparent crystal.

Determination of crystal axis by back-reflection Laue method and cutting-out

For $Ca_{(2-x)}Sr_xMgSi_2O_7$ (x = 0.10), since a boundary between single crystals was configured in a plane, the single crystals were cut out along the boundary surfaces using a diamond cutter. The cut-out single crystal was fixed to a goniometer, and a Laue photograph of the cut-out surface was captured using a back-reflection Laue X-ray device (Rigaku, Geiger flex). The exposure time to X-rays was set to approximately one minute, and the set values of the tube voltage and the tube current for generation of X-rays were set to 40 kV and 25 mA, respectively. As a target, tungsten was used such that continuous X-rays having a high intensity could be obtained. Fig. 9 shows captured Laue spots. From the fact that spots showed fourfold symmetry in all of the cut-out surfaces that were parallel with the boundary surface, it was found that the boundary surface was a c surface.

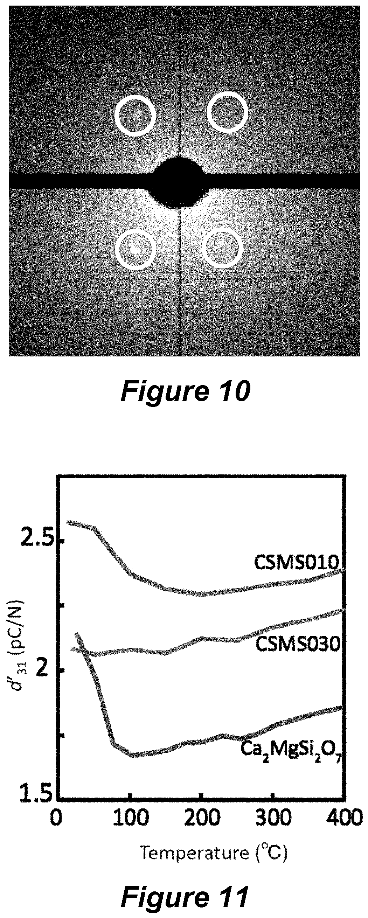

For $Ca_{(2-x)}Sr_xMgSi_2O_7$ (x = 0.30), since a plane was confirmed in an orientation in which a side surface of a crystal grown in the a axis was divided into four parts, a Laue photograph was captured from one surface thereof. Fig. 10 shows captured Laue spots. Since the spots showed twofold symmetry, it was found that the surface was an a surface.

This confirmed that the grown crystals of $Ca_{(2-x)}Sr_xMgSi_2O_7$ (x = 0.10, 0.30) were all single crystals.

After the determination of the orientations of the individual samples, Z-cut plate-shaped samples having a thickness of 1 mm in a direction perpendicular to the c axis were cut out with a wire saw. Furthermore, plate-shaped samples for piezoelectric measurement (1 x 3 x 12 mm³) of (ZXt) 45° were cut out from these samples as piezoelectric members. Chips generated during the cutting-out were removed by polishing with #2000 waterproof abrasive paper, sputtering was carried out under conditions of 5 mA and 10 minutes using Au as a target, and electrodes were formed on the front surfaces and rear surfaces of the cut-out piezoelectric members.

Piezoelectric elements were produced in the above-described order.

Next, for samples of the produced piezoelectric elements, the piezoelectric constants $d'_{31}$ at room temperature were measured as the characteristic values of the piezoelectric elements. In the measurement of the piezoelectric constants $d'_{31}$, resonant and antiresonant frequencies were measured using an impedance analyzer (Agilent, 4294A), and the piezoelectric constants $d'_{31}$ were determined based on the measured frequencies. The obtained piezoelectric constants are shown in Table 1.

[Table 1]

|  | Piezoelectric constant d'$_{31}$ [pC/N] |
|---|---|
| $Ca_{(2-x)}Sr_xMgSi_2O_7$ (x = 0.10) | 2.6 |
| $Ca_{(2-x)}Sr_xMgSi_2O_7$ (x = 0.30) | 2.1 |

As a result, it was confirmed that, in $Ca_{(2-x)}Sr_xMgSi_2O_7$ (x = 0.10, 0.30), values approximately the same as the piezoelectric constant $d_{12}$ (= 2.3 pCN) of quartz were obtained, and the values were sufficient piezoelectric constants as piezoelectric elements.

Next, the impedances were measured in a state where the samples were put into an electric furnace, and the piezoelectric constants were measured in a range of room temperature to 400°C. Fig. 11 shows the temperature dependencies of the piezoelectric constants measured from the samples of the piezoelectric elements of the examples. Fig. 11 also shows the temperature dependency of $Ca_2MgSi_2O_7$ shown in Chuanying Shen et al. (2015) J. Appl. Phys. 117, 064106.

For $Ca_{(2-x)}Sr_xMgSi_2O_7$ (x = 0.10) (expressed as CSMS010 in Fig. 11), similar to akermanite, an increase in $d'_{31}$ is observed on the low-temperature side, and the influence of phase transition is considered to remain. On the other hand, for $Ca_{(2-x)}Sr_xMgSi_2O_7$ (x = 0.30 (expressed as CSMS030 in Fig. 11)), it is found that $d'_{31}$ changes linearly, the amount of the change is approximately 10%, and the temperature dependency is low. Therefore, Sr-substituted akermanite can be said to satisfy the conditions in terms of piezoelectricity, and particularly, X is preferably 0.30 or more.

Next, for the samples of the piezoelectric elements produced as the examples and samples of piezoelectric elements produced using different piezoelectric materials as comparative examples, the piezoelectric constants $d_{ij}$ and the electric resistivity were measured as the characteristic values of the piezoelectric elements at different temperatures.

The piezoelectric materials used in the comparative examples are $GaPO_4$ (gallium phosphate), CTGS $(Ca_3TaGa_3Si_2O_{14})$, CTAS $(Ca_3TaAl_3Si_2O_{14})$, LTGA $(La_3Ta_{0.5}Ga_{5.5-x}AlxO_{14})$, LTG $(La_3Ta_{0.5}Ga_{5.5}O_{14})$, LGS $(La_3Ga_5SiO_{14})$ and YCOB $(YCa_4O(BO_3)_3)$.

An impedance analyzer (HP4294A) manufactured by Hewlett-Packard Company was used for the measurement of the individual characteristic values. The piezoelectric constants $d_{ij}$ were obtained by measuring and calculating the electromechanical coupling coefficients ($k_{ij}$ and $k_p$) of the individual samples by a resonant and antiresonant method. In addition, the electric resistivity was measured by a three-terminal method. The piezoelectric constant that is expressed as $d_{ij}$ is only the piezoelectric constant $d_{31}$ of CSMS030, which is because the other crystals were evaluated with $d_{11}$. The reason for the fact that $d_{11}$ and $d_{31}$ may be compared with each other is that those piezoelectric constants serve as a performance index for using the materials as devices.

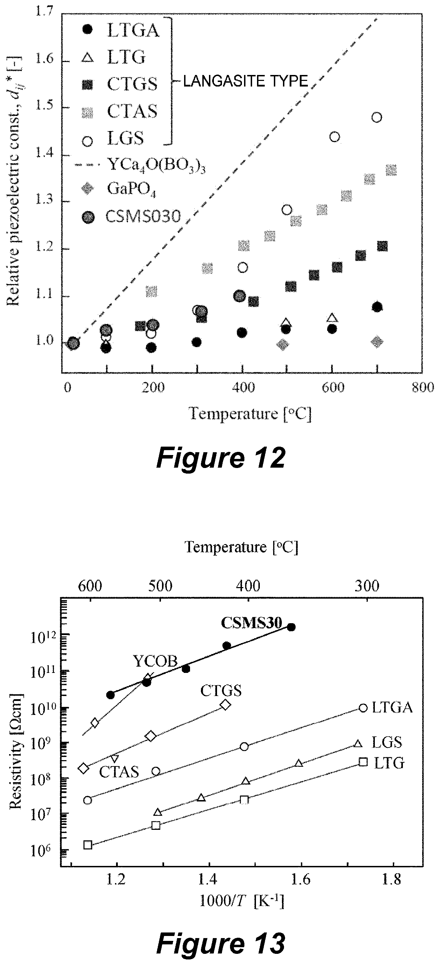

Fig. 12 is a view showing the temperature dependencies of the piezoelectric constants measured from the samples of the piezoelectric elements produced as the examples and the comparative examples. Here, for the graph shown in Fig. 12, the horizontal axis indicates temperatures (Celsius), and the vertical axis indicates relative piezoelectric constants $d_{ij}$*. Here, the relative piezoelectric constant $d_{ij}$* refers to a relative value to the piezoelectric constant $d_{ij}$ at room temperature and is calculated from Equation (1).

$$d* = (d_{ij} \text{ at each temperature})/(d_{ij} \text{ at room temperature}) \cdots \text{ Equation (1)}$$

Room temperature refers to a temperature within a range of 15°C to 35°C.

As shown in Fig. 12, for the sample produced using $Ca_{(2-x)}Sr_xMgSi_2O_7$ (x = 0.30), which was the example, (expressed as CSMS030 in Fig. 12), it is found that the amount of the piezoelectric constant $d_{31}$ changed from room temperature to the high-temperature region is small and stable piezoelectric characteristics can be obtained. The temperature stability of these piezoelectric characteristics shows approximately the same degree of safety as langasite-type crystals for which temperature changes are large.

In addition, as shown in Fig. 13, it is found that the samples of the present examples show a high electric resistivity even in the high-temperature region and maintain excellent insulating properties even in the high-temperature region compared with the comparative examples.

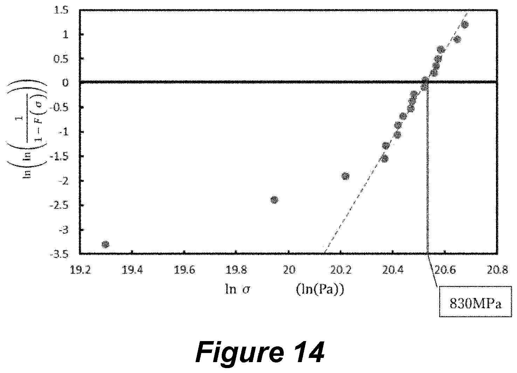

For the samples cut out from the crystal bulk body of $Ca_{(2-x)}Sr_xMgSi_2O_7$ (x = 0.30) into a (1 x 1 x 2.5 mm$^3$) rod shape in an orientation of (ZXt) 45°, the compressive break strengths were measured using a compression tester. The compression rate was set to 1 mm/min. The number of measurement samples was set to 16, and the compressive break strengths were measured at room temperature. Fig. 14 shows a Weibull plot of the compressive break strength test results of $Ca_{(2-x)}Sr_xMgSi_2O_7$ (x = 0.30). A linear approximation was carried out on the Weibull plot, and the x-intercept shows that the compressive strength of $Ca_{(2-x)}Sr_xMgSi_2O_7$ (x = 0.30) was 830 MPa. This value is approximately four times the compressive strength of gehlenite-based piezoelectric crystals (XZt) 45° that has been reported and significantly exceeds the target value of 300 MPa, which is 10 times the pressure in gasoline engines.

As described above, the use of Sr-substituted akermanite represented by $Ca_{(2-x)}Sr_xMgSi_2O_7$ ($0.1 \leq x < 0.6$) as a piezoelectric material makes it possible to produce piezoelectric elements that can be used in high-temperature environments.

In addition, the produced piezoelectric elements can be used as sensors such as pressure sensors or ultrasonic sensors. For such pressure sensors, application as the above-described combustion pressure sensors in combustion chambers of engines is conceivable. In addition, it is conceivable as application that the ultrasonic sensors are installed in the external walls of boilers, steam piping, turbines or the like in high-temperature plants in thermal power stations to monitor the high-temperature plants.

The application of the piezoelectric element according to the present invention is not limited thereto. Since the Sr-substituted akermanite represented by $Ca_{(2-x)}Sr_xMgSi_2O_7$ ($0.1 \leq x < 0.6$) undergoes no phase transition and has no Curie temperature until the melting point, in principle, piezoelectric elements produced using the Sr-substituted akermanite as a piezoelectric material can be used in a broad range of application as elements that can be used in broad temperature environments from room temperature through lower than the melting point of the Sr-substituted akermanite.

Reference Signs List

1        Piezoelectric element

2        Piezoelectric member

3        Electrode

4        Electrode

10      Crystal growth device

30      Pressure sensor

31      Case material

32      Diaphragm

33      Insulating sleeve

34      Base

35      Alumina plate

36      Sealing material

37      Fixing screw

38, 39   Electric wire

**Claims**

1. A piezoelectric material composed of Sr-substituted akermanite represented by $Ca_{(2-x)}Sr_xMgSi_2O_7$ ($0.1 \leq x \leq 0.6$).

2. A piezoelectric member comprising, as a main component, the piezoelectric material according to claim 1.

3. The piezoelectric member according to claim 2, which is cut in an orientation of (ZXt) $\theta$ ($30° \leq \theta \leq 60°$) when two a axes of a unit lattice of a tetragonal crystal of the Sr-substituted akermanite are X axis and Y axis, and c axis is Z axis.

4. A piezoelectric element comprising:

the piezoelectric member according to claim 2 or 3; and

at least a pair of electrodes provided on surfaces that are orthogonal to a stress application surface of the piezoelectric member and face each other.

5. A pressure sensor comprising:

a diaphragm; and

the piezoelectric element according to claim 4,

wherein the piezoelectric element is provided such that stress that arises from pressure that is applied through the diaphragm is transmitted to the stress application surface of the piezoelectric member and charges that are generated in the piezoelectric member due to the stress can be detected through the electrodes.

**Figure 1**

**Figure 2**

```
        ┌─────────────┐
        │    START    │
        └──────┬──────┘
               │
               ▼
    ┌──────────────────────┐
    │ CRYSTAL GROWTH STEP  │  ⎰ S10
    └──────────┬───────────┘
               │
               ▼
    ┌──────────────────────┐
    │ CRYSTAL CUTTING-OUT  │  ⎰ S11
    │        STEP          │
    └──────────┬───────────┘
               │
               ▼
    ┌──────────────────────┐
    │  ELECTRODE FORMING   │  ⎰ S12
    │        STEP          │
    └──────────┬───────────┘
               │
               ▼
        ┌─────────────┐
        │     END     │
        └─────────────┘
```

*Figure 3*

*Figure 4*

STRESS
(PRESSURE)

Figure 5

*Figure 6*

*Figure 7*

*Figure 8*

*Figure 9*

*Figure 10*

*Figure 11*

Figure 12

Figure 13

*Figure 14*

## INTERNATIONAL SEARCH REPORT

| International application No. |
| --- |
| PCT/JP2020/024226 |

**A. CLASSIFICATION OF SUBJECT MATTER**
G01L 1/16(2006.01)i; G01L 23/10(2006.01)i; H01L 41/053(2006.01)i; H01L 41/113(2006.01)i; H01L 41/187(2006.01)i; H01L 41/22(2013.01)i; H01L 41/338(2013.01)i
FI: H01L41/187; H01L41/113; H01L41/338; H01L41/22; H01L41/053; G01L1/16 A; G01L23/10

According to International Patent Classification (IPC) or to both national classification and IPC

**B. FIELDS SEARCHED**

Minimum documentation searched (classification system followed by classification symbols)
G01L1/16; G01L23/10; H01L41/053; H01L41/113; H01L41/187; H01L41/22; H01L41/338

Documentation searched other than minimum documentation to the extent that such documents are included in the fields searched
| | |
| --- | --- |
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2017-183550 A (CITIZEN WATCH CO., LTD.) 05.10.2017 (2017-10-05) paragraph [0030], fig. 1-12 | 1-5 |
| A | US 2014/0327340 A1 (ENERGY STORAGE MATERIALS LLC) 06.11.2014 (2014-11-06) paragraphs [0030]-[0033], fig. 1-8 | 1-5 |
| A | WO 2006/077756 A1 (NATIONAL INSTITUTE OF ADVANCED INDUSTRIAL SCIENCE AND TECHNOLOGY) 27.07.2006 (2006-07-27) paragraph [0023], fig. 1-8 | 1-5 |

☒ Further documents are listed in the continuation of Box C.    ☒ See patent family annex.

| | | |
| --- | --- | --- |
| * | Special categories of cited documents: | |
| "A" | document defining the general state of the art which is not considered to be of particular relevance | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 17 August 2020 (17.08.2020) | 25 August 2020 (25.08.2020) |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

| International application No. |
| --- |
| PCT/JP2020/024226 |

C (Continuation).　DOCUMENTS CONSIDERED TO BE RELEVANT

| Category* | Citation of document, with indication, where appropriate, of the relevant passages | Relevant to claim No. |
| --- | --- | --- |
| A | 大島拓人，(Ca,Ae2+)2A12Si07(Ae=Sr,Ba)の単結晶育成と電気的・機械的特性の評価，第 37 回エレクトロセラミックス研究討論会講演予稿集，12 October 2017, pp. 76-77, in particular, p. 76, line 11 from the bottom, non-official translation (OSHIMA, Takuto, "Single crystal growth of (Ca,Ae2+)2A12Si07(Ae=Sr,Ba) and evaluation of electrical and mechanical characteristics", Lecture preprints of the 37th Electronics division meeting of the Ceramic Society of Japan) | 1-5 |
| P,X<br>P,A | 日下部展，Sr 置換オケルマナイト単結晶の育成と電気的・機械的特性評価，第 39 回電子材料研究討論会講演予稿集，28 November 2019, p. 142, in particular, p. 142, lines 6-15 from the bottom, non-official translation (KUSAKABE, Hikaru, "Growth of Sr-substituted akermanite single crystal and evaluation of electrical and mechanical characteristics", Lecture preprints of the 39th Electronics division meeting of the Ceramic Society of Japan) | 1-3<br>4,5 |

Form PCT/ISA/210 (continuation of second sheet) (January 2015)

**INTERNATIONAL SEARCH REPORT**
Information on patent family members

International application No.

PCT/JP2020/024226

| Patent Documents referred in the Report | Publication Date | Patent Family | Publication Date |
|---|---|---|---|
| JP 2017-183550 A | 05 Oct. 2017 | (Family: none) | |
| US 2014/0327340 A1 | 06 Nov. 2014 | (Family: none) | |
| WO 2006/077756 A1 | 27 Jul. 2006 | US 2009/0012431 A1 paragraph [0041], fig. 1-8 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5966683 B

- JP 2017183550 A

**Non-patent literature cited in the description**

- **CHUANYING SHEN et al.** *J. Appl. Phys.,* 2015, vol. 117, 064106